# EUROPÄISCHE PATENTSCHRIFT

(11) **EP 2 997 801 B1**
(45) Veröffentlichungstag und Bekanntmachung des Hinweises auf die Patenterteilung: **17.10.2018**
(21) Anmeldenummer: 14723401.7
(22) Anmeldetag: 05.05.2014
(51) Int. Cl.: H05K 7/14, H01L 25/07

(54) **VORRICHTUNG UND ELEKTRISCHE BAUGRUPPE ZUM WANDELN EINER GLEICHSPANNUNG IN EINE WECHSELSPANNUNG**
DEVICE AND ELECTRICAL ASSEMBLY FOR CONVERTING A DIRECT VOLTAGE INTO AN ALTERNATING VOLTAGE
DISPOSITIF ET MODULE ÉLECTRIQUE PERMETTANT DE CONVERTIR UNE TENSION CONTINUE EN TENSION ALTERNATIVE

(30) Priorität: 14.05.2013 DE 102013008193
(43) Veröffentlichungstag der Anmeldung: 23.03.2016
(73) Patentinhaber: Audi AG, 85045 Ingolstadt (DE); Volkswagen AG, 38440 Wolfsburg (DE)
(72) Erfinder: DOMURAT-LINDE, André, 13351 Berlin (DE); HOENE, Eckart, 13465 Berlin (DE); ENZINGER, Tobias, 86558 Hohenwart (DE); RINKLEFF, Thomas, 85057 Inglostadt (DE)
(74) Vertreter: 2SPL Patentanwälte PartG mbB
(86) Internationale Anmeldenummer: PCT/EP2014/059095
(87) Internationale Veröffentlichungsnummer: WO 2014/184030

(56) Entgegenhaltungen:
- EP-A1- 1 376 696
- WO-A1-2013/018811
- DE-A1- 10 101 086
- US-A1- 2004 227 231

## Beschreibung

Ausführungsbeispiele der vorliegenden Erfindung befassen sich mit elektrischen Baugruppen, insbesondere mit solchen, mittels denen eine Gleichspannung in eine Wechselspannung gewandelt werden kann.

Anwendungen, in denen solche auch als Wechselrichter bezeichneten Baugruppen verwendet werden, sind zahlreich. Beispielsweise werden u.a. im Camping- Bereich Wechselrichter eingesetzt, um aus der Gleichspannung des Bordnetzes eines Kraftfahrzeugs oder eines Caravans, also beispielsweise aus 12 V Versorgungsspannung, eine einphasige Wechselspannung, wie sie in den Wechselspannungsnetzen mit einer effektiven Spannung von 220 V gebräuchlich ist, zu erzeugen, um herkömmliche Geräte auch mobil betreiben zu können.

Zur Erzeugung der Wechselspannung wird eine negative konstante Versorgungsspannung sowie eine positive konstante Versorgungsspannung von zwei elektrischen Schaltern bzw. Leistungshalbleitern mit hoher Frequenz auf einen Wechselspannungsausgang geschalten, um die positiven bzw. negativen Halbwellen der Ausgangswechselspannung zu erzeugen. Derartige Wechselrichter sind nicht nur in einphasigen Ausführungen sondern auch in zwei- oder dreiphasigen Ausführungen erhältlich. Die einzelnen als Schalter verwendeten Leistungshalbleiter werden typischerweise innerhalb eines einzigen Moduls, d.h. auf einer gemeinsamen Platine bzw. einem Printed Circuit Board (PCB) als eine elektrische Baugruppe montiert, oft mit zusätzlichen Bauteilen, die die Funktionalität ergänzen, wie beispielsweise parallel zu den Leistungshalbleitern geschalteten Freilaufdioden.

Eine neuere wichtige Anwendung für solche elektrischen Baugruppen, mittels denen es möglich ist, ein- oder mehrphasige Wechselspannungen aus einer Gleichspannung zu erzeugen, sind elektrifizierte Kraftfahrzeuge, in denen diese Baugruppen verwendet werden, um die für den geregelten Betrieb eines Elektromotors zum Antrieb des Fahrzeugs benötigten Wechselspannungen zu erzeugen. Dabei werden üblicherweise hohe elektrische Leistungen umgesetzt, sodass die zum Schalten der Versorgungsspannungen auf die betreffenden Wechselspannungsausgänge der Module bzw. elektrischen Baugruppen verwendeten Leistungshalbleiter, beispielsweise Insulated Gate Bipolar Transistoren (IGBT's), gekühlt werden müssen. Dies verhindert, dass diese aufgrund der inhärenten Leistungsverluste in den einzelnen Bauteilen selbst zerstört werden. Die Module bzw. die elektrischen Baugruppen zur Spannungswandlung verwenden dabei üblicherweise zur Erzeugung jeder Phase jeweils ein Paar von Leistungshalbleitern bzw. Halbleiterschaltern des gleichen Typs, die mit einer hohen Schaltgeschwindigkeiten betrieben werden, um die Wechselspannung der betreffenden Phase zu erzeugen. Aufgrund der hohen Schaltgeschwindigkeiten und der teilweise erheblichen geschalteten Leistungen können diese elektrischen Baugruppen erheblichen Störungen im Bordnetz des Fahrzeugs verursachen. Solche dynamischen Störungen können Frequenzen bis zu einigen 100 MHz haben und so abseits der zum Betrieb des Fahrzeugs erforderlichen Funktionen beispielsweise auch den Radioempfang, den Empfang von Fernsehen, den digitalen Radioempfang sowie weitere Komfortfunktionen im Fahrzeug stören. Zusätzlich besteht die Gefahr, dass durch Einstreuen der hochfrequenten Störungen im Fahrzeug möglicherweise sicherheitsrelevante Systeme, wie Datenbussysteme im Fahrzeug gestört werden können.

Dokument EP 1 376 696 A1 beschreibt eine Halbleitervorrichtung mit zumindest zwei steuerbaren Halbleiterschaltern, die in Brückenform geschaltet sind, um an einem oberen Arm und einem unteren Arm eines Wechselrichters Gleichstrom in Wechselstrom umzuwandeln. Die Halbleitervorrichtung weist ferner zumindest einen Ausgabeanschluss, zumindest einen Positiv- und einen Negativ- Polaritäts-Gleichstromanschluss und ein Isoliersubstrat auf, welches einen Leiterabschnitt einschließt, um auf diesem die Halbleiterschalter anzubringen. Im Isoliersubstrat sind abwechselnd laminiert zumindest zwei Leiterschichten mit Leiterabschnitten auf ihrer Oberfläche und einem Leiter in ihrer Innenschicht und mit zumindest zwei Isolierschichten angeordnet, wobei die Leiterabschnitte auf ihrer Oberfläche und der Innenschichtleiter die Halbleiterschalter und die Gleichstromanschlüsse verbinden, sowie die Oberflächenleiterabschnitte und die Innenschicht-Leiterschicht durch Durchleiter elektrisch verbunden sind, die durch die zwischen die Leiterschichten eingefügte Isolierschicht hindurchgehen. Ein Strompfad ist so angeordnet, dass ein Strom, der durch den Positiv-Polaritäts-Anschluss, einen Positiv-Polaritäts-Gleichstromanschluss-verbundenen Leiter, einen Durchleiter, die Innenschicht-Leiterschicht und den Durchleiter fließt, von entgegengesetzter Richtung zu einem Strom ist, der durch den Halbleiterschalter, den auf dem Halbleiterschalter angebrachten Leiterabschnitt, den Halbleiterschalter und den Negativ-Polaritäts-Gleichstromanschluss fließt.

Es besteht daher das Bedürfnis, elektrische Baugruppen zum Wandeln einer Gleichspannung in eine Wechselspannung zur Verfügung zu stellen, die geringere Störungen in den sie umgebenden Netzen bzw. in den Versorgungsspannungsnetzen verursachen.

Einige Ausführungsbeispiele der Erfindung ermöglichen dies durch Verwendung einer elektrische Baugruppe zum Wandeln einer Gleichspannung in eine Wechselspannung, die eine erste Versorgungsspannungsfläche zum Verteilen einer ersten Versorgungsgleichspannung und eine zweite Versorgungsspannungsfläche zum Verteilen einer zweiten Versorgungsgleichspannung, sowie zumindest einen ersten Leistungshalbleiter mit einem mit der ersten Versorgungsspannungsfläche verbundenen Eingangsanschluss und einem mit einem Wechselspannungsausgang der Baugruppe verbundenen Ausgangsanschluss sowie einen zweiten Leistungshalbleiter mit einem mit der zweiten Versorgungsspannungsfläche verbundenen Eingangsanschluss und einem mit dem Wechselspannungsausgang der Schaltung verbundenen Ausgangsanschluss aufweist. Um die elektromagnetische Verträglichkeit (EMV) zu erhöhen, bzw. die Ausstrahlung von Störungen zu verringern, erstreckt sich sowohl die zweite Versorgungsspannungsfläche auf der dem Eingangsanschluss des zweiten Leistungshalbleiters abgewandten Seite desselben als auch die erste Versorgungsspannungsfläche auf der dem Eingangsspannungsanschluss des ersten Leistungshalbleiters zugewandten Seite des ersten Leistungshalbleiters. Auch wenn es zur elektrischen Kontaktierung zumindest des zweiten Leistungshalbleiters ausreichend sein könnte, die ihm zugeordnete zweite Versorgungsspannungsfläche lediglich bis an den zweiten Leistungshalbleiter heranzuführen, wenn sich dessen Eingangsspanungsanschluss auf der der Versorgungsspannungsfläche abgewandten Seite des Leistungshalbleiters befindet, wird die elektrische Baugruppe so aufgebaut, dass sich die zweite Versorgungsspannungsfläche auch auf der dem Eingangsspannungsanschluss abgewandten Seite des zweiten Leistungshalbleiters und somit unterhalb desselben erstreckt. Dies kann bewirken, dass sich dadurch auch zwischen dem Ausgangsanschluss des zweiten Leistungshalbleiters und weiteren metallischen Flächen der elektrischen Baugruppe, beispielsweise Kühlblechen oder dergleichen, die zweite Versorgungsspannungsfläche erstreckt, welche so eine Abschirmwirkung bezüglich weiterer metallischer Gegenstände entfalten kann. Dies kann insbesondere von Vorteil sein, wenn sich der Ausgangsanschluss auf der den weiteren, abzuschirmenden Bauteilen zugewandten Seite des Leistungshalbleiters befindet, da dann die Kapazität zwischen dem Ausgangsanschluss und den weiteren metallischen Bauteilen besonders groß wäre. Dies wäre in Verbindung mit den hohen Frequenzen, die durch die geschaltete Spannung am Ausgangsanschluss des Leistungshalbleiters auftreten, eine potentielle Störquelle, die Störungen in die umgebenden Systeme einstreuen könnte. Durch die zusätzliche Abschirmung können solche Störungen möglicherweise teilweise unterdrückt werden.

Gemäß einigen weiteren Ausführungsbeispielen der vorliegenden Erfindung ist zu diesem Zweck der zweite Leistungshalbleiter auf einem zusätzlichen Substrat angeordnet, welches an einer Oberfläche eine Leiterstruktur aufweist, die mit dem Ausgangsanschluss des zweiten Leistungshalbleiters direkt verbunden ist, wobei das Substrat zwischen dem zweiten Leistungshalbleiter und der zweiten Versorgungsspannungsfläche angeordnet ist. Das verwenden eines zusätzlichen Substrats bzw. eines zusätzlichen PCB's ermöglicht es auf einfache Art und Weise, auch bei Verwendung zweier identischer Leistungshalbleiter, die Versorgungsspannungsfläche unterhalb des Leistungshalbleiters zu führen, ohne dessen Ausgang kurzzuschließen. Darüber hinaus kann durch die Verwendung eines weiteren Substrates, mittels dessen der Ausgangsanschluss des zweiten Leistungshalbleiters kontaktiert wird, auf kostengünstige und dennoch flexible Art und Weise die gewünschte Funktionalität zur Verfügung gestellt werden. Zusätzlich kann durch das zusätzliche Substrat der Abstand zwischen dem in Hinblick auf die Erzeugung von Störungen besonders kritischen Ausgangsanschluss des Leistungshalbleiters und den benachbarten metallischen Strukturen vergrößert werden, sodass dadurch zusätzlich die Kapazität, die der Ausgangsanschluss mit den umgebenden metallischen Bauteilen unweigerlich bildet, verringert wird. Das Verringern dieser parasitären Kapazität kann weiter dazu beitragen, die mittels der hohen Schaltfrequenzen erzeugten Störungen zu minimieren. Als Substrat in diesem Sinne ist somit jeder dreidimensionale Körper zu verstehen, der intrinsisch elektrisch isolierend ist, auf, an oder in dem jedoch elektrisch leitende Strukturen bzw. Leiterbahnen angeordnet werden können bzw. sind.

Ergänzend zu den die parasitäre Ausgangskapazität des Leistungshalbleiters betreffenden Maßnahmen kann gemäß einigen Ausführungsbeispielen der vorliegenden Erfindung die elektromagnetische Verträglichkeit weiter verbessert werden, indem die elektrische Baugruppe hinsichtlich weiterer Merkmale bzw. Schaltungsteile symmetrisch ausgelegt wird. Um dies zu ermöglichen, werden gemäß einigen Ausführungsbeispielen der vorliegenden Erfindung die erste und die zweite Versorgungsspannungsfläche hinsichtlich der geometrischen Fläche näherungsweise identisch ausgelegt. Das bedeutet, dass die sich innerhalb einer Ebene erstreckende erste Versorgungsspannungsfläche und die sich innerhalb einer weiteren Ebene erstreckende zweite Versorgungsspannungsfläche einen Flächenunterschied von beispielsweise weniger als zehn Prozent, bevorzugt weniger als fünf Prozent aufweisen, sodass die in den Versorgungsspannungszweigen induzierten Störungen bzw. Schaltströme sich symmetrisch verhalten bzw. ausbreiten, was insgesamt die elektromagnetische Störaussendung verringern kann. D.h., das Verwenden eines geeigneten Platinenlayouts bzw. eines geeigneten Layouts der elektrischen Baugruppe kann dazu führen, die Störausstrahlung weiter zu verringern.

Gemäß einigen weiteren Ausführungsbeispielen erstrecken sich die Versorgungsspannungsflächen innerhalb derselben Ebene und sind darüber hinaus bezüglich einer zwischen diesen beiden Flächen befindlichen Symmetrieachse symmetrisch. Eine vollständig symmetrische Auslegung der Versorgungsspannungsflächen bzw. des Zwischenkreises kann die elektromagnetische Verträglichkeit weiter verbessern.

Gemäß einigen weiteren Ausführungsbeispielen sind die beiden Versorgungsspannungsflächen mittels zumindest eines Kondensators miteinander gekoppelt, sodass sich möglicherweise symmetrisch induzierte Ströme nicht erst im Fernfeld teilweise kompensieren, sondern darüber hinaus möglicherweise eine zumindest teilweise Kompensation der Störung am Ort der Erzeugung derselben erfolgen kann. Dadurch kann gemäß einigen Ausführungsbeispielen die Aussendung von störenden elektromagnetischen Wellen weiter verringert werden.

Gemäß einigen Ausführungsbeispielen der vorliegenden Erfindung werden als Leistungshalbleiter jeweils Insulated Gate Bipolar Transistoren (IGBT's) desselben Typs verwendet, sodass zusätzliche Störungen aufgrund von unterschiedlichen Bauteileauslegungen bzw. Herstellungsverfahren vermieden werden können.

Gemäß einigen weiteren Ausführungsbeispielen der Erfindung werden die Versorgungsspannungsflächen niederinduktiv angebunden, d.h., ohne eine hohe Induktivität aufzuweisen, die zu einem Aussenden von störenden elektromagnetischen Feldern führen könnte. Zu diesem Zweck werden die Kontaktierungen der ersten und der zweiten Versorgungsspannungsfläche jeweils als flächige Kontakte bis an den Rand eines Gehäuses geführt, wo diese von extern kontaktiert werden können. Eine zusätzliche Schirmwirkung für die verwendeten Leistungshalbleiter bzw. IGBT's kann möglicherweise erzielt werden, wenn sich die zur Kontaktierung verwendeten flächigen Leiterstrukturen zu beiden Seiten der Leistungshalbleiter erstrecken. D.h., beispielsweise kann gemäß einigen Ausführungsbeispielen die zweite Versorgungsspannungsfläche auf einer Seite der Leistungshalbleiter bis zum Rand des Gehäuses verlängert werden, und es kann die erste Versorgungsspannungsfläche auf der gegenüberliegenden Seite der Leistungshalbleiter bis an den Rand des Gehäuses geführt werden, sodass die Leistungshalbleiter von den beiden metallischen Flächen umschlossen sind, was zu einer weiteren Abschirmung der für das Aussenden der Störungen relevanten Komponenten, insbesondere der Ausgangsanschlüsse der Leistungshalbleiter führen kann.

Gemäß einigen Ausführungsbeispielen befindet sich auf der von den Leistungshalbleitern abgewandten Seite der Versorgungsspannungsflächen ein Keramiksubstrat, auf dem die Versorgungsspannungsflächen aufgebracht sind, sodass diese zum einen dem Übertragen der elektrischen Leistung dienen können und zum anderen der Ankopplung eines Kühlsystems über die keramische Fläche bzw. die Keramik, welches zum kontinuierlichen Betrieb der elektrischen Baugruppe erforderlich sein kann.

Weitere Ausführungsbeispiele der vorliegenden Erfindung können, um einen langzeitstabilen Betrieb zu ermöglichen, auf der von den Leistungshalbleitern abgewandten Seite des Keramiksubstrats beispielsweise einen metallischen Kühlkörper aufweisen, um eine Kühlung zu gewährleisten und so kostengünstig und in integrierter Bauweise die Langlebigkeit der elektrischen Baugruppe zu verbessern.

Gemäß einigen weiteren Ausführungsbeispielen der vorliegenden Erfindung weist die elektrische Baugruppe ein weiteres Paar oder zwei weitere Paare identischer Leistungshalbleiter auf, die mit einem zweiten Wechselspannungsausgang bzw. mit einem dritten Wechselspannungsausgang der elektrischen Baugruppe verbunden sind, sodass mittels weiterer Ausführungsbeispiele der vorliegenden Erfindung auch zweiphasige- oder drei-phasige bzw. in weiteren Ausführungsformen beliebig-phasige Wechselströme erzeugt werden können, ohne das signifikante Störungen in das Bordnetz bzw. in umgebende elektrische Netze bzw. Funknetze eingestreut werden.

Ausführungsbeispiele der vorliegenden Erfindung werden nachfolgend, bezugnehmend auf die beiliegenden Figuren, näher erläutert. Es zeigen:
- Fig. 1: ein Ausführungsbeispiel einer elektrischen Baugruppe zum Wandeln einer Gleichspannung in eine Wechselspannung;
- Fig. 2: eine Schnittansicht durch die herkömmliche Anordnung, in der ein Leistungshalbleiter in einer Baugruppe gemäß Figur 1 alternativ montiert werden kann.
- Fig. 3: eine Gegenüberstellung einer herkömmlichen, auch in Figur 2 gezeigten Anordnung mit einer Anordnung gemäß einem Ausführungsbeispiel der vorliegenden Erfindung;
- Fig. 4: ein weiteres Ausführungsbeispiel einer elektrischen Baugruppe;
- Fig. 5: ein weiteres Ausführungsbeispiel einer elektrischen Baugruppe;
- Fig. 6: ein weiteres Ausführungsbeispiel einer elektrischen Baugruppe; und
- Fig. 7: eine schematische Darstellung der Verwendung einer elektrischen Baugruppe in einem Kraftfahrzeug.

Verschiedene Ausführungsbeispiele werden nun ausführlicher unter Bezugnahme auf die beiliegenden Zeichnungen beschrieben, in denen einige Ausführungsbeispiele dargestellt sind. In den Figuren können die Dickenabmessungen von Linien, Schichten und/oder Regionen um der Deutlichkeit Willen übertrieben dargestellt sein.

Bei der nachfolgenden Beschreibung der beigefügten Figuren, die lediglich einige exemplarische Ausführungsbeispiele zeigen, können gleiche Bezugszeichen gleiche oder vergleichbare Komponenten bezeichnen. Ferner können zusammenfassende Bezugszeichen für Komponenten und Objekte verwendet werden, die mehrfach in einem Ausführungsbeispiel oder in einer Zeichnung auftreten, jedoch hinsichtlich eines oder mehrerer Merkmale gemeinsam beschrieben werden. Komponenten oder Objekte, die mit gleichen oder zusammenfassenden Bezugszeichen beschrieben werden, können hinsichtlich einzelner, mehrerer oder aller Merkmale, beispielsweise ihrer Dimensionierungen, gleich, jedoch gegebenenfalls auch unterschiedlich ausgeführt sein, sofern sich aus der Beschreibung nicht etwas anderes explizit oder implizit ergibt.

Obwohl Ausführungsbeispiele auf verschiedene Weise modifiziert und abgeändert werden können, sind Ausführungsbeispiele in den Figuren als Beispiele dargestellt und werden hierin ausführlich beschrieben. Es sei jedoch klargestellt, dass nicht beabsichtigt ist, Ausführungsbeispiele auf die jeweils offenbarten Formen zu beschränken, sondern dass Ausführungsbeispiele vielmehr sämtliche funktionale und/oder strukturelle Modifikationen, Äquivalente und Alternativen, die im Bereich der Erfindung liegen, abdecken sollen. Gleiche Bezugszeichen bezeichnen in der gesamten Figurenbeschreibung gleiche oder ähnliche Elemente.

Man beachte, dass ein Element, das als mit einem anderen Element "verbunden" oder "verkoppelt" bezeichnet wird, mit dem anderen Element direkt verbunden oder verkoppelt sein kann oder dass dazwischenliegende Elemente vorhanden sein können. Wenn ein Element dagegen als "direkt verbunden" oder "direkt verkoppelt" mit einem anderen Element bezeichnet wird, sind keine dazwischenliegenden Elemente vorhanden. Andere Begriffe, die verwendet werden, um die Beziehung zwischen Elementen zu beschreiben, sollten auf ähnliche Weise interpretiert werden (z.B., "zwischen" gegenüber "direkt dazwischen", "angrenzend" gegenüber "direkt angrenzend" usw.).

Die Terminologie, die hierin verwendet wird, dient nur der Beschreibung bestimmter Ausführungsbeispiele und soll die Ausführungsbeispiele nicht beschränken. Wie hierin verwendet, sollen die Singularformen "einer", "eine", "eines" und "der, die, das" auch die Pluralformen beinhalten, solange der Kontext nicht eindeutig etwas anderes angibt. Ferner sei klargestellt, dass die Ausdrücke wie z.B. "beinhaltet", "beinhaltend", aufweist" und/oder "aufweisend", wie hierin verwendet, das Vorhandensein von genannten Merkmalen, ganzen Zahlen, Schritten, Arbeitsabläufen, Elementen und/oder Komponenten angeben, aber das Vorhandensein oder die Hinzufügung von einem bzw. einer oder mehreren Merkmalen, ganzen Zahlen, Schritten, Arbeitsabläufen, Elementen, Komponenten und/oder Gruppen davon nicht ausschließen.

Solange nichts anderes definiert ist, haben sämtliche hierin verwendeten Begriffe (einschließlich von technischen und wissenschaftlichen Begriffen) die gleiche Bedeutung, die ihnen ein Durchschnittsfachmann auf dem Gebiet, zu dem die Ausführungsbeispiele gehören, beimisst. Ferner sei klargestellt, dass Ausdrücke, z.B. diejenigen, die in allgemein verwendeten Wörterbüchern definiert sind, so zu interpretieren sind, als hätten sie die Bedeutung, die mit ihrer Bedeutung im Kontext der einschlägigen Technik konsistent ist, und nicht in einem idealisierten oder übermäßig formalen Sinn zu interpretieren sind, solange dies hierin nicht ausdrücklich definiert ist.

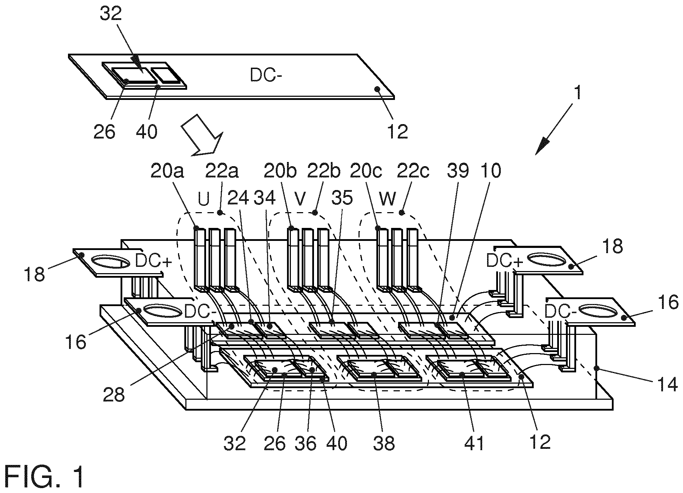

Figur 1 zeigt ein Ausführungsbeispiel einer elektrischen Baugruppe 1 zum Wandeln einer Gleichspannung in eine Wechselspannung. Die elektrische Baugruppe 1 weist eine erste Versorgungsspannungsfläche 10 zum Verteilen einer ersten Versorgungsgleichspannung in der Baugruppe auf, sowie eine zweite Versorgungsspannungsfläche 12 zum Verteilen einer zweiten Versorgungsgleichspannung. Bei dem in Figur 1 gezeigten Beispiel ist ohne Einschränkung die Konfiguration der verwendeten Leistungshalbleiter und der Versorgungsspannungen so gewählt, dass die erste Versorgungsspannungsfläche 10 von einer positiven Versorgungsspannung versorgt werden soll und die zweite Versorgungsspannungsfläche 12 von einer negativen Versorgungsspannung. Um die Versorgungsspannungsflächen von außerhalb eines die elektrische Baugruppe umschließenden Gehäuses 14 kontaktieren zu können, sind bei dem in Figur 1 gezeigten Ausführungsbeispiel die Versorgungsspannungsflächen 10 und 12 mittels Bonddrähten zu beiden Seiten des Gehäuses 14 mit Versorgungsspannungsklemmen 16 und 18 verbunden.

Die in Figur 1 gezeigte elektrische Baugruppe dient dem Erzeugen eines dreiphasigen Wechselstroms mit den Phasen U, V und W, die jeweils an einem Wechselspannungsausgang 20a, 20b und 20c abgegriffen werden können. Da sich die Beschaltung der verwendeten IGBT's zur Erzeugung der einzelnen Phasen innerhalb der die Phasen jeweils erzeugenden einzelnen Wechselspannungszweige 22a, 22b und 22c abseits der hier der Übersichtlichkeit nicht dargestellten Ansteuerung der Gate-Elektroden nicht unterscheidet, wird nachfolgend die elektrische Baugruppe bzw. deren Aufbau und Funktionalität ausschließlich anhand des ersten Wechselspannungszweigs 22a beschrieben.

Dieser weist einen ersten Leistungshalbleiter 24 bzw. einen ersten IGBT und einen zweiten Leistungshalbleiter 26 bzw. IGBT auf. Der erste Leistungshalbleiter 24 weist einen Eingangsanschluss auf, der in Richtung der ersten Versorgungsspannungsfläche 10 weist und mit dieser direkt verbunden ist. Das heißt, der vertikale Leistungshalbleiter 24 bzw. der einen vertikal durch das Halbleiterbauteil verlaufenden Stromfluss ermöglichende IGBT ist mit seinem Eingangsanschluss direkt mit einer Metallisierung bzw. einer Kupferleitbahn auf der Oberfläche der Versorgungsspannungsfläche 10 verbunden. Ein von der Versorgungsspannungsfläche 10 wegweisender Ausgangsanschluss 28 ist mit dem Wechselspannungsausgang 20a mittels Bonddrähten verbunden.

Der Ausgangsanschluss des zweiten Leistungshalbleiters 26 ist mittels Bonddrähten über den Ausgangsanschluss 28 des ersten Leistungshalbleiters 24 ebenfalls mit dem Wechselspannungsausgang 20a verbunden. Dabei ist der Ausgangsanschluss des zweiten Leistungshalbleiters 26 jedoch auf der der zweiten Versorgungsspannungsfläche 12 zugewandten Seite des Leistungshalbleiters 26 angeordnet. Der dieser Fläche abgewandte Eingangsanschluss 32 ist mittels Bonddrähten mit der zweiten Versorgungsspannungsfläche 12 verbunden. Das heißt, bei den hier gezeigten Ausführungsbeispielen befinden sich die Eingangs- bzw. Ausgangsanschlüsse der vertikalen Leistungshalbleiter teilweise direkt auf der Oberfläche von Leiterbahnen, die zur Verschaltung der Bauteile verwendet werden. Parallel zu den jeweiligen Leistungshalbleitern sind auf an sich übliche Art und Weise Freilaufdioden 34 und 36 geschalten, auf deren Funktionsbeschreibung hierin jedoch verzichtet werden soll. Wenngleich hier überwiegend durch die Verwendung von Bonddrähten illustriert, kann bei weiteren Ausführungsbeispielen die elektrische Kontaktierung zwischen den jeweils leitend verbundenen Elementen auf beliebige andere Art und Weise hergestellt werden, beispielsweise mittels isolierten Litzen, starren Leitern oder ähnliches.

Um verglichen mit einer nachfolgend kurz diskutierten herkömmlichen Beschaltungen bzw. elektrischen Baugruppen zur Erzeugung von Wechselspannungen die elektromagnetische Verträglichkeit zu verbessern, erstreckt sich sowohl bei dem ersten Leistungshalbleiter 24 als auch bei dem zweiten Leistungshalbleiter 26, die diesem jeweilig zugeordnete Versorgungsspannungsfläche 10 bzw. 12 auch unterhalb der Leistungshalbleiter 24 und 26. Wenngleich dies aus Gründen der Kontaktierung im Fall des ersten Leistungshalbleiters 24 möglicherweise noch üblich sein mag, wird dies bei dem in Figur 1 gezeigten Ausführungsbeispiel durch ein zu diesem Zweck durch ein zwischen dem zweiten Leistungshalbleiter 26 und der zweiten Versorgungsspannungsfläche 12 angeordnetes zusätzliches Substrat 40 ermöglicht. Der Ausgangsanschluss des zweiten Leistungshalbleiters 26 ist direkt mit einer Metallisierung bzw. einer Leiterbahn auf der Oberfläche dieses Substrats 40 verbunden bzw. verlötet, sodass es durch das isolierende Substrat 40 auf der Oberfläche der zweiten Versorgungsspannungsfläche 12 möglich wird, dass sich diese vollständig auch unterhalb des zweiten Leistungshalbleiters 26 erstreckt.

Als Ausgangsanschluss soll hierin allgemein, unabhängig davon, ob es sich dabei möglicherweise um einen Kollektor oder einen Emitter eines Leistungshalbleiters bzw. eines IGBTs handelt, derjenige Anschluss verstanden werden, welcher dazu verwendet wird, mittels des Leistungshalbleiters die Spannung an den Ausgang bzw. den Wechselspannungsausgang 20a zu schalten. Dazu korrespondierend soll als Eingangsanschluss eines Leistungshalbleiters im hierin verwendeten Sinne derjenige Anschluss verstanden werden, der mit der Versorgungsspannung elektrisch leitend verbunden ist.

Bei Verwendung von identischen IGBT's bei dem in Figur 1 gezeigten Ausführungsbeispiel wäre der Eingangsanschluss des zweiten Leistungshalbleiters 26 der Emitter desselben und der Ausgangsanschluss wäre der Kollektor des zweiten Leistungshalbleiters 26. Gegengesetzt dazu wäre der Kollektor des ersten Leistungshalbleiters 24 der Eingangsanschluss und der Emitter des zweiten Leistungshalbleiters 24 wäre der Ausgangsanschluss desselben. Wenngleich hierin mit IGBT's als Leistungshalbleiter bzw. Leistungsschalter beschrieben, können in anderen Ausführungsbeispielen der Erfindung auch andere, insbesondere vertikale, leistungsschaltende Elemente verwendet werden, beispielsweise Feld Effekt Transistoren (FET's), Power MOS FET's oder dergleichen.

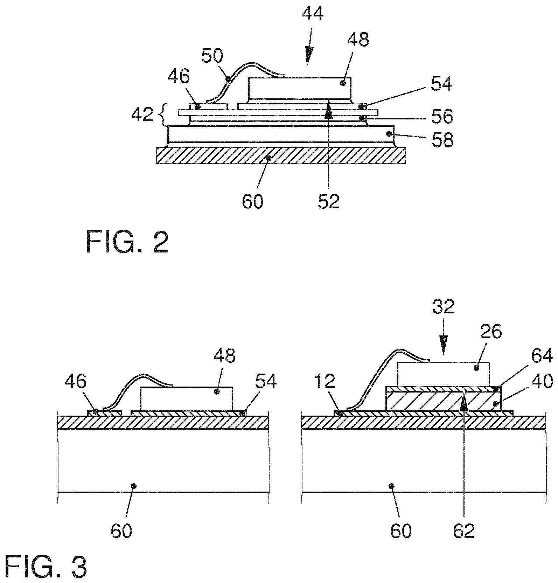

Figur 2 zeigt zum Vergleich in einer Schnittansicht eine herkömmliche Beschaltung bzw. eine herkömmlichen Konfiguration für den zweiten Leistungshalbleiter 26. Herkömmlich, d. h., ohne das Substrat 40, würde für die in Figur 1 dargestellte Konfiguration ein Leistungshalbleiter auf einem PCB 42 angebracht, der Eingangsanschluss 44 würde mit einer Kupferleiterbahn 46, die sich bis zum Leistungshalbleiter 48 erstreckt, mittels eines Bonddrahtes 50 kontaktiert. Der Ausgangsanschluss 52 würde direkt mit einer weiteren Leiterbahn 54 verlötet. Auf der Rückseite des PCB befindet sich typischerweise ebenfalls eine Kupferschicht 56, die in guter thermischer Kopplung mit einem Träger 58 der Baugruppe verlötet wird, an dessen Rückseite sich typischerweise wiederum ein Kühlkörper 60 befindet, um die im Betrieb entstehende Abwärme abzuführen. Durch die herkömmliche Anordnung der Figur 2 erstreckt sich jedoch die Versorgungsspannungsfläche 46 nicht bis unterhalb des Ausgangsanschlusses 52, wie dies gemäß den Ausführungsbeispielen der Erfindung der Fall ist. Dadurch bildet der Ausgangsanschlusses 52 eine vergleichsweise hohen parasitäre Kapazität unter anderem mit dem metallischen Kühlkörper. Diesbezüglich ist die in Figur 2 gezeigte Konfiguration besonders nachteilig, da sich der hochfrequent geschaltete Ausgangsanschluss 52 räumlich nahe an den weiteren metallischen bzw. leitenden Bauelementen befindet.

Figur 3 zeigt in der linken Darstellung die in Figur 2 gezeigte herkömmliche Konfiguration erneut in einer schematischen Darstellung im Schnitt. Dem gegenüber gestellt ist auf der rechten Seite der Figur 3 eine vereinfachte geschnittene Darstellung der gemäß den Ausführungsbeispielen der Erfindung verwendeten Beschaltung bzw. Konfiguration des zweiten Leistungshalbleiters 26, der auf einem zusätzlichen Substrat 40 angeordnet ist, sodass sich dessen Ausgangsanschluss 62 unmittelbar mit einer Leiterstruktur 64 auf der Oberfläche des Substrats 40 verlöten lässt. Dadurch wird es ermöglicht, dass sich die zweite Versorgungsspannungsfläche 12 bis unterhalb bzw. vollständig unterhalb des zweiten Leistungshalbleiters 26 erstreckt, was zum einen eine Abschirmung des Ausgangsanschlusses 62, beispielsweise bezüglich des Kühlkörpers 60, zur Folge hat. Darüber hinaus wird durch den größeren Abstand zu demselben die parasitäre Kapazität reduziert, was beides zu einer deutlichen Reduzierung der Störungen führen kann bzw. zu einer Verbesserung der EMV erfindungsgemäßer elektrische Baugruppen.

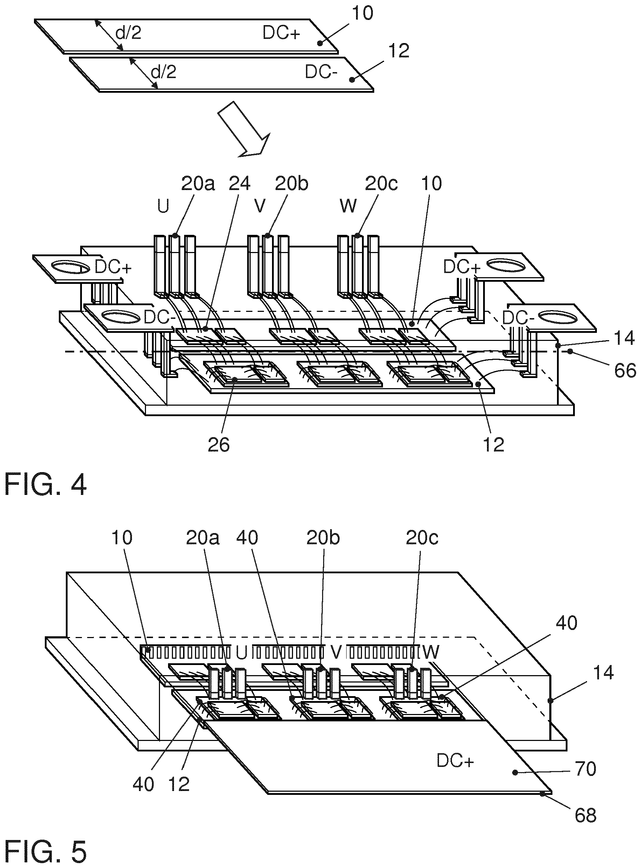

Figur 4 zeigt ein weiteres Ausführungsbeispiel der vorliegenden Erfindung, das in einer Vielzahl von Merkmalen auf dem anhand der Figur 1 beschriebenen Ausführungsbeispiel basiert, sodass nachfolgend lediglich auf die Unterschiede eingegangen wird.

Bei dem in Figur 4 gezeigten Ausführungsbeispiel wird die EMV weiter verbessert, indem der Zwischenkreis symmetrisch ausgeführt wird. Um dies zu erzielen, sind die beiden sich in derselben Ebene erstreckenden Versorgungsspannungsflächen 10 und 12 zum einen bezüglich ihrer geometrischen Fläche identisch und zum anderen symmetrisch bezüglich einer gemeinsamen Symmetrieachse 66, was jeweils bereits für sich genommen die EMV verbessern kann. Durch die in Figur 4 gezeigte Konfiguration der vollsymmetrischen Auslegung bzw. Zwischenkreisführung kann die EMV des in Figur 1 gezeigten Ausführungsbeispiels weiter verbessert werden.

Figur 5 zeigt ein weiteres Ausführungsbeispiel der Erfindung, das in seinen Grundzügen auf den bereits anhand der Figuren 1 und 3 diskutierten Ausführungsbeispielen beruht, so dass auch hier vorliegend lediglich die Unterschiede bezüglich dieser Ausführungsbeispiele kurz diskutiert werden sollen. Bei dem in Figur 5 gezeigten Ausführungsbeispiel wird der Zwischenkreis nach außen niederinduktiv angebunden. Das heißt, die zur Verbindung der ersten und zweiten Versorgungsspannungsflächen 10 und 12 erforderlichen Kontaktierungen nach außerhalb des Gehäuses 14 weisen eine niedrige Induktivität auf. Dies wird vorliegend dadurch erreicht, dass die Kontaktierungen in Form von metallischen Flächen nach außen geführt werden, wozu beispielsweise, wie in Figur 5 gezeigt, die zweite Versorgungsspannungsfläche 12 mit einer flächigen zweiten Kontaktierung 68 nach außerhalb des Gehäuses 14 verlängert wird. Ferner erstreckt sich bei dem in Figur 5 gezeigten Ausführungsbeispiel auch die erste Kontaktierung 70 flächig bis an den Rand des Gehäuses 14, um dort mit den Versorgungsspannungsquellen verbunden werden zu können. Bei dem in Figur 5 gezeigten Ausführungsbeispiel werden darüber hinaus die Leistungshalbleiter zu beiden Seiten von den elektrisch leitenden Kontaktierungen 68 und 70 bzw. den Versorgungsspannungsflächen 10 und 12 umschlossen, sodass diese Art der Anbindung zusätzlich zu der Vermeidung von unerwünschten Induktivtäten im Zwischenkreis einen weiteren Abschirmungseffekt bewirken kann.

Ferner ist bei dem in Figur 5 gezeigten Ausführungsbeispiel auch die Anbindung der Wechselspannungsausgänge 20a bis 20c niederinduktiv ausgeführt, d. h., auf die Verwendung von Bonddrähten wird verzichtet, indem die Wechselspannungsausgänge 20a bis 20c direkt auf den zusätzlichen Substraten 40 verlötet sind.

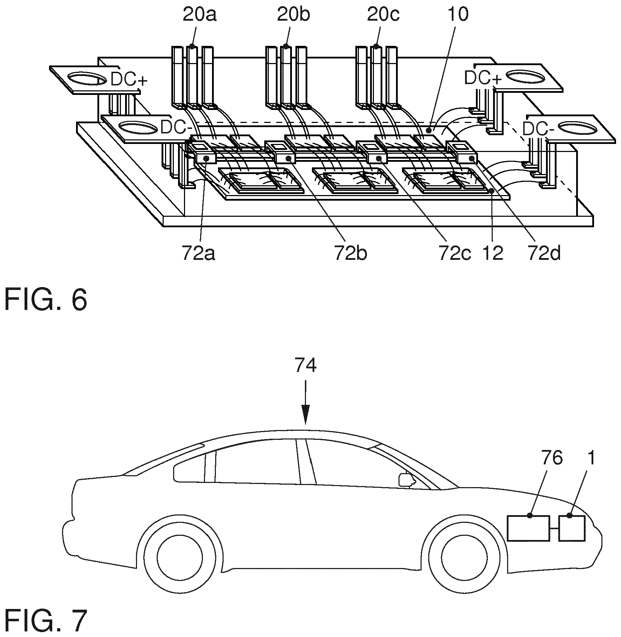

Figur 6 zeigt ein weiteres Ausführungsbeispiel der vorliegenden Erfindung, bei dem durch die Verwendung von mehreren Kondensatoren 72a bis 72d, die einerseits mit der ersten Versorgungsspannungsfläche 10 und andererseits mit der zweiten Versorgungsspannungsfläche 12 verbunden sind, eine weitere Verbesserung der EMV der elektrischen Baugruppe 1 erreicht wird. Prinzipiell ist es bereits vorteilhaft, wenn die erste Versorgungsspannungsfläche (10) und die zweite Versorgungsspannungsfläche (12) mittels zumindest eines Kondensators miteinander gekoppelt sind. Gemäß weiteren Ausführungsbeispielen können die Versorgungsspannungsflächen auch über mehrere Kondensatoren verbunden sein. Gemäß einigen weiteren Ausführungsbeispielen können die beiden Versorgungsspannungsflächen auch mit mehreren Kondensatoren auch unterschiedlichen Typs bzw. unterschiedlicher Kapazität miteinander verbunden werden, was zu einer Unterdrückung von Störungen über einen erweiterten Frequenzbereich führen kann.

Gemäß den vorhergehend beschriebenen Ausführungsbeispielen der vorliegenden Erfindung können Ausführungsbeispiele erfindungsgemäßer elektrischer Baugruppen in einem Kraftfahrzeug zum Einsatz kommen, insbesondere in hochspannungsführenden Teilen, beispielsweise bei der Ansteuerung von elektrischen Antriebsmotoren oder dergleichen.

Figur 7 zeigt der Vollständigkeit halber eine schematische Darstellung der Verwendung einer elektrischen Baugruppe 1 in einem Kraftfahrzeug 74. Das Kraftfahrzeug 74 umfasst zumindest einem elektrischen Antriebsmotor 76, der mittels einer mit dem Antriebsmotor 76 verbundenen elektrischen Baugruppe 1 gemäß einem der Ausführungsbeispiele der Erfindung angesteuert wird.

Wenngleich die vorhergehenden Ausführungsbeispiele überwiegend im Kontext vom Kraftfahrzeug- Anwendungen beschrieben wurden, können weitere Ausführungsbeispiele erfindungsgemäßer elektrischer Baugruppen auch in anderen Anwendungsszenarien Verwendung finden, beispielsweise in stationären Anlagen, dort beispielsweise in Industrieumrichtern von Solaranlagen, Windkraftanlagen, Wasserkraftanlagen oder dergleichen.

Die in der vorstehenden Beschreibung, den nachfolgenden Ansprüchen und den beigefügten Figuren offenbarten Merkmale können sowohl einzeln wie auch in beliebiger Kombination für die Verwirklichung eines Ausführungsbeispiels in ihren verschiedenen Ausgestaltungen von Bedeutung sein und implementiert werden.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

## Patentansprüche

1. Elektrische Baugruppe (1) zum Wandeln einer Gleichspannung in eine Wechselspannung, mit folgenden Merkmalen :
einer ersten Versorgungsspannungsfläche (10) zum Verteilen einer ersten Versorgungsgleichspannung;
einer zweiten Versorgungsspannungsfläche (12) zum Verteilen einer zweiten Versorgungsgleichspannung;
zumindest einem ersten Leistungshalbleiter (24) mit einem mit der ersten Versorgungsspannungsfläche (12) verbundenen Eingangsanschluss und einem mit einem Wechselspannungsausgang (20a) der Baugruppe verbundenem Ausgangsanschluss (28);
zumindest einem zweiten Leistungshalbleiter (26) mit einem mit der zweiten Versorgungsspannungsfläche (12) verbundenen Eingangsanschluss (32) und einem mit dem Wechselspannungsausgang (20a) der Baugruppe verbundenen Ausgangsanschluss, wobei
sich die erste Versorgungsspannungsfläche (10) auf der dem Eingangsspannungsanschluss des ersten Leistungshalbleiters (24) zugewandten Seite des ersten Leistungshalbleiters (24) erstreckt, sich die zweite Versorgungsspannungsfläche (12) auf der dem Eingangsspannungsanschluss (32) des zweiten Leistungshalbleiters (26) abgewandten Seite des zweiten Leistungshalbleiters (26) erstreckt; und wobei
der zweite Leistungshalbleiter (26) auf einem zusätzlichen Substrat (40) angeordnet ist, das an einer Oberfläche des Substrats (40) eine Leiterstruktur aufweist, die mit dem Ausgansanschluss des zweiten Leistungshalbleiters (28) verbunden ist, wobei das Substrat (40) zwischen dem zweiten Leistungshalbleiter (28) und der zweiten Versorgungsspannungsfläche (12) angeordnet ist.

2. Elektrische Baugruppe (1) nach Anspruch 1, **dadurch gekennzeichnet, dass** die erste Versorgungsspannungsfläche (10) und die zweite Versorgungsspannungsfläche (12) sich jeweils flächig innerhalb einer Ebene erstrecken, wobei sich ein erster Flächeninhalt der ersten Versorgungsspannungsfläche (10) weniger als 10% von einem zweiten Flächeninhalt der zweiten Versorgungsspannungsfläche (12) unterscheidet.

3. Elektrische Baugruppe (1) nach einem der vorhergehenden Ansprüche, **dadurch gekennzeichnet, dass** sich die erste Versorgungsspannungsfläche (10) und die zweite Versorgungsspannungsfläche (12) innerhalb derselben Ebene erstrecken.

4. Elektrische Baugruppe (1) nach einem der vorhergehenden Ansprüche, **dadurch gekennzeichnet, dass** die erste Versorgungsspannungsfläche (10) und die zweite Versorgungsspannungsfläche (12) bezüglich einer Symmetrieachse (66) symmetrisch zueinander angeordnet sind.

5. Elektrische Baugruppe (1) nach einem der vorhergehenden Ansprüche, **dadurch gekennzeichnet, dass** die erste Versorgungsspannungsfläche (10) und die zweite Versorgungsspannungsfläche (12) mittels zumindest eines Kondensators (72a-d) miteinander gekoppelt sind.

6. Elektrische Baugruppe (1) nach einem der vorhergehenden Ansprüche, **dadurch gekennzeichnet, dass** es sich bei dem ersten Leistungshalbleiter (24) und dem zweiten Leistungshalbleiter (26) jeweils um eine Insulated Gate Bipolar Transistor (IGBT) desselben Typs handelt.

7. Elektrische Baugruppe (1) nach einem der vorhergehenden Ansprüche, **dadurch gekennzeichnet, dass** die Baugruppe zumindest teilweise von einem Gehäuse (14) umgeben ist, wobei sich eine zweite Kontaktierung (68) der zweiten Versorgungsspannungsfläche (12) in einer Verlängerung der Fläche der zweiten Versorgungsspannungsfläche (12) bis an den Rand des Gehäuses (14) erstreckt und wobei sich eine erste Kontaktierung (70) der ersten Versorgungsspannungsfläche (10) als eine parallel zur zweiten Kontaktierung (68) verlaufende Fläche bis an den Rand des Gehäuses (14) erstreckt, wobei die erste Kontaktierung (70) und die zweite Kontaktierung (68) auf einander gegenüberliegenden Seiten des ersten Leistungshalbleiters (24) und des zweiten Leistungshalbleiter (26) angeordnet sind.

8. Elektrische Baugruppe (1) nach einem der vorhergehenden Ansprüche, **dadurch gekennzeichnet, dass** der Ausgangsanschluss (28) des ersten Leistungshalbleiters (24) auf der der ersten Versorgungsspannungsfläche (10) abgewandten Seite des ersten Leistungshalbleiters angeordnet ist, wobei der Ausgangsanschluss des zweiten Leistungshalbleiters (26) auf der der zweiten Versorgungsspannungsfläche (12) zugewandten Seite des zweiten Leistungshalbleiters (26) angeordnet ist.

9. Elektrische Baugruppe (1) nach einem der vorhergehenden Ansprüche, **dadurch gekennzeichnet, dass** sich auf der von dem ersten Leistungshalbleiter (24) und dem zweiten Leistungshalbleiter (26) abgewandten Seite der ersten Versorgungsspannungsfläche (10) und der zweiten Versorgungsspannungsfläche (12) ein Keramiksubstrat befindet.

10. Elektrische Baugruppe nach Anspruch 9, **dadurch gekennzeichnet, dass** sich auf der von dem ersten Leistungshalbleiter (24) und dem zweiten Leistungshalbleiter (26) abgewandten Seite des Keramiksubstrats ein metallischer Kühlkörper (60) befindet.

11. Elektrische Baugruppe (1) nach einem der vorhergehenden Ansprüche, **dadurch gekennzeichnet, dass** die Baugruppe ferner eine dritten Leistungshalbleiter (35) mit einem mit der ersten Versorgungsspannungsfläche (10) verbundenen Eingangsanschluss und einem mit einem zweiten Wechselspannungsausgang (20b) der Baugruppe (1) verbundenen Ausgangsanschluss; sowie
einen vierten Leistungshalbleiter (38) mit einem mit der zweiten Versorgungsspannungsfläche (12) verbundenen Eingangsanschluss und einem mit dem zweiten Wechselspannungsausgang (20b) der Baugruppe verbundenen Ausgangsanschluss aufweist, wobei die zweite Versorgungsspannungsfläche (12) auf der dem Eingangsspannungsanschluss des vierten Leistungshalbleiters (38) abgewandten Seite des vierten Leistungshalbleiters (38) erstreckt und dass sich die erste Versorgungsspannungsfläche (10) auf der dem Eingangsspannungsanschluss des dritten Leistungshalbleiters (35) zugewandten Seite des dritten Leistungshalbleiters (35) erstreckt.

12. Elektrische Baugruppe (1) nach Anspruch 11, **dadurch gekennzeichnet, dass** die Baugruppe ferner einen fünften Leistungshalbleiter (39) mit einem mit der ersten Versorgungsspannungsfläche (10) verbundenen Eingangsanschluss und einem mit einem dritten Wechselspannungsausgang (20c) der Schaltung verbundenen Ausgangsanschluss; sowie
einen sechsten Leistungshalbleiter (41) mit einem mit der zweiten Versorgungsspannungsfläche (12) verbundenen Eingangsanschluss und einem mit dem dritten Wechselspannungsausgang (20c) der Baugruppe (1) verbundenen Ausgangsanschluss aufweist, wobei sich die zweite Versorgungsspannungsfläche (12) auf der dem Eingangsspannungsanschluss des sechsten Leistungshalbleiters (41) abgewandten Seite des sechsten Leistungshalbleiters (41) erstreckt und dass sich die erste Versorgungsspannungsfläche (10) auf der dem Eingangsspannungsanschluss des fünften Leistungshalbleiters (39) zugewandten Seite des fünften Leistungshalbleiters erstreckt.

13. Kraftfahrzeug (74) mit zumindest einem elektrischen Antriebsmotor (76) und mit einer mit dem Antriebsmotor (76) verbundenen elektrischen Baugruppe (1) gemäß einem der vorhergehenden Ansprüche.

## Claims

1. Electrical assembly (1) for converting a DC voltage into an AC voltage, with the following features:
a first supply voltage area (10) for distributing a first DC supply voltage;
a second supply voltage area (12) for distributing a second DC supply voltage;
at least one first power semiconductor (24) having an input terminal connected to the first supply voltage area (12) and an output terminal (28) connected to an AC voltage output (20a) of the assembly;
at least one second power semiconductor (26) having an input terminal (32) connected to the second supply voltage area (12) and an output terminal connected to the AC voltage output (20a) of the assembly, wherein
the first supply voltage area (10) extends on the side of the first power semiconductor (24) facing the input voltage terminal of the first power semiconductor (24), the second supply voltage area (12) extends on the side of the second power semiconductor (26) facing away from the input voltage terminal (32) of the second power semiconductor (26); and wherein
the second power semiconductor (26) is arranged on an additional substrate (40), which comprises at a surface of the substrate (40) a conductor structure which is connected to the output terminal of the second power semiconductor (28), wherein the substrate (40) is arranged between the second power semiconductor (28) and the second supply voltage area (12) .

2. Electrical assembly (1) according to Claim 1, **characterized in that** the first supply voltage area (10) and the second supply voltage area (12) each extend two-dimensionally within one plane, wherein a first surface area of the first supply voltage area (10) differs by less than 10% from a second surface area of the second supply voltage area (12).

3. Electrical assembly (1) according to one of the preceding claims, **characterized in that** the first supply voltage area (10) and the second supply voltage area (12) extend within the same plane.

4. Electrical assembly (1) according to one of the preceding claims, **characterized in that** the first supply voltage area (10) and the second supply voltage area (12) are arranged symmetrically in relation to one another with respect to an axis of symmetry (66).

5. Electrical assembly (1) according to one of the preceding claims, **characterized in that** the first supply voltage area (10) and the second supply voltage area (12) are coupled to one another by at least one capacitor (72a-d).

6. Electrical assembly (1) according to one of the preceding claims, **characterized in that** the first power semiconductor (24) and the second power semiconductor (26) are each an insulated gate bipolar transistor (IGBT) of the same type.

7. Electrical assembly (1) according to one of the preceding claims, **characterized in that** the assembly is at least partly surrounded by a housing (14), wherein a second contacting (68) of the second supply voltage area (12) extends as an extension of the area of the second supply voltage area (12) up to the edge of the housing (14), and wherein a first contacting (70) of the first supply voltage area (10), as an area running parallel to the second contacting (68), extends up to the edge of the housing (14), wherein the first contacting (70) and the second contacting (68) are arranged on opposite sides of the first power semiconductor (24) and the second power semiconductor (26).

8. Electrical assembly (1) according to one of the preceding claims, **characterized in that** the output terminal (28) of the first power semiconductor (24) is arranged on the side of the first power semiconductor facing away from the first supply voltage area (10), wherein the output terminal of the second power semiconductor (26) is arranged on the side of the second power semiconductor (26) facing the second supply voltage area (12).

9. Electrical assembly (1) according to one of the preceding claims, **characterized in that** on the side of the first supply voltage area (10) and the second supply voltage area (12) facing away from the first power semiconductor (24) and the second power semiconductor (26) there is a ceramic substrate.

10. Electrical assembly (1) according to Claim 9, **characterized in that** on the side of the ceramic substrate facing away from the first power semiconductor (24) and the second power semiconductor (26) there is a metallic heat sink (60).

11. Electrical assembly (1) according to one of the preceding claims, **characterized in that** the assembly further comprises a third power semiconductor (35) having an input terminal connected to the first supply voltage area (10) and an output terminal connected to the second AC voltage output (20b) of the assembly (1); and
a fourth power semiconductor (38) having an input terminal connected to the second supply voltage area (12) and an output terminal connected to the second AC voltage output (20b) of the assembly, wherein the second supply voltage area (12) extends on the side of the fourth power semiconductor (38) facing away from the input voltage terminal of the fourth power semiconductor (38) and that the first supply voltage area (10) extends on the side of the third power semiconductor (35) facing the input voltage terminal of the third power semiconductor (35).

12. Electrical assembly (1) according to Claim 11, **characterized in that** the assembly further comprises a fifth power semiconductor (39) having an input terminal connected to the first supply voltage area (10) and an output terminal connected to a third AC voltage output (20c) of the circuit; and
a sixth power semiconductor (41) having an input terminal connected to the second supply voltage area (12) and an output terminal connected to the third AC voltage output (20c) of the assembly (1), wherein the second supply voltage area (12) extends on the side of the sixth power semiconductor (41) facing away from the input voltage terminal of the sixth power semiconductor (41), and that the first supply voltage area (10) extends on the side of the fifth power semiconductor facing the input voltage terminal of the fifth power semiconductor (39).

13. Motor vehicle (74) having at least one electrical drive motor (76) and having an electrical assembly (1) according to one of the preceding claims connected to the drive motor (76).

## Revendications

1. Module électrique (1) permettant de convertir une tension continue en une tension alternative, présentant les caractéristiques suivantes :
une première surface de tension d'alimentation (10) permettant de répartir une première tension continue d'alimentation ;
une deuxième surface de tension d'alimentation (12) permettant de répartir une deuxième tension continue d'alimentation ;
au moins un premier semi-conducteur de puissance (24) présentant une borne d'entrée reliée à la première surface de tension d'alimentation (12) et une borne de sortie (28) reliée à une sortie de tension alternative (20a) du module ;
au moins un deuxième semi-conducteur de puissance (26) présentant une borne d'entrée (32) reliée à la deuxième surface de tension d'alimentation (12) et une borne de sortie reliée à la sortie de tension alternative (20a) du module, dans lequel
la première surface de tension d'alimentation (10) s'étend sur la face du premier semi-conducteur de puissance (24) qui est tournée vers la borne de tension d'entrée du premier semi-conducteur de puissance (24),
la deuxième surface de tension d'alimentation (12) s'étend sur la face du deuxième semi-conducteur de puissance (26) qui est opposée à la borne de tension d'entrée (32) du deuxième semi-conducteur de puissance (26) ; et dans lequel
le deuxième semi-conducteur de puissance (26) est disposé sur un substrat supplémentaire (40) présentant sur une surface du substrat (40) une structure conductrice reliée à la borne de sortie du deuxième semi-conducteur de puissance (28), dans lequel le substrat (40) est disposé entre le deuxième semi-conducteur de puissance (28) et la deuxième surface de tension d'alimentation (12).

2. Module électrique (1) selon la revendication 1, **caractérisé en ce que** la première surface de tension d'alimentation (10) et la deuxième surface de tension d'alimentation (12) s'étendent respectivement de manière plane dans un plan, dans lequel une première superficie de la première surface de tension d'alimentation (10) diffère de moins de 10 % d'une deuxième superficie de la deuxième surface de tension d'alimentation (12).

3. Module électrique (1) selon l'une des revendications précédentes, **caractérisé en ce que** la première surface de tension d'alimentation (10) et la deuxième surface de tension d'alimentation (12) s'étendent dans le même plan.

4. Module électrique (1) selon l'une des revendications précédentes, **caractérisé en ce que** la première surface de tension d'alimentation (10) et la deuxième surface de tension d'alimentation (12) sont disposées symétriquement l'une de l'autre par rapport à un axe de symétrie (66).

5. Module électrique (1) selon l'une des revendications précédentes, **caractérisé en ce que** la première surface de tension d'alimentation (10) et la deuxième surface de tension d'alimentation (12) sont couplées l'une à l'autre au moyen d'au moins un condensateur (72a-d).

6. Module électrique (1) selon l'une des revendications précédentes, **caractérisé en ce que** le premier semi-conducteur de puissance (24) et le deuxième semi-conducteur de puissance (26) sont respectivement un transistor bipolaire à grille isolée (IGBT) du même type.

7. Module électrique (1) selon l'une des revendications précédentes, **caractérisé en ce que** le module est entouré au moins partiellement d'un boîtier (14), dans lequel un deuxième contact (68) de la deuxième surface de tension d'alimentation (12) s'étend dans un prolongement de l'étendue de la deuxième surface de tension d'alimentation (12) jusqu'au bord du boîtier (14) et dans lequel un premier contact (70) de la première surface de tension d'alimentation (10) s'étend sous la forme d'une étendue qui s'étend parallèlement au deuxième contact (68) jusqu'au bord du boîtier (14), dans lequel le premier contact (70) et le deuxième contact (68) sont disposés sur des faces opposées du premier semi-conducteur de puissance (24) et du deuxième semi-conducteur de puissance (26).

8. Module électrique (1) selon l'une des revendications précédentes, **caractérisé en ce que** la borne de sortie (28) du premier semi-conducteur de puissance (24) est disposée sur la face du premier semi-conducteur de puissance qui est opposée à la première surface de tension d'alimentation (10), dans lequel la borne de sortie du deuxième semi-conducteur de puissance (26) est disposée sur la face du deuxième semi-conducteur de puissance (26) qui est tournée vers la deuxième surface de tension d'alimentation (12).

9. Module électrique (1) selon l'une des revendications précédentes, **caractérisé en ce qu'**un substrat céramique est situé sur la face de la première surface de tension d'alimentation (10) et de la deuxième surface de tension d'alimentation (12) qui est opposée au premier semi-conducteur de puissance (24) et au deuxième semi-conducteur de puissance (26).

10. Module électrique selon la revendication 9, **caractérisé en ce qu'**un corps de refroidissement métallique (60) est situé sur la face du substrat céramique qui est opposée au premier semi-conducteur de puissance (24) et au deuxième semi-conducteur de puissance (26).

11. Module électrique (1) selon l'une des revendications précédentes, **caractérisé en ce que** le module comprend en outre un troisième semi-conducteur de puissance (35) présentant une borne d'entrée reliée à la première surface de tension d'alimentation (10) et une borne de sortie reliée à une deuxième sortie de tension alternative (20b) du module (1) ; et
un quatrième semi-conducteur de puissance (38) présentant une borne d'entrée reliée à la deuxième surface de tension d'alimentation (12) et une borne de sortie reliée à la deuxième sortie de tension alternative (20b) du module, dans lequel la deuxième surface de tension d'alimentation (12) s'étend sur la face du quatrième semi-conducteur de puissance (38) qui est opposée à la borne de tension d'entrée du quatrième semi-conducteur de puissance (38), et que la première surface de tension d'alimentation (10) s'étend sur la face du troisième semi-conducteur de puissance (35) qui est tournée vers la borne de tension d'entrée du troisième semi-conducteur de puissance (35).

12. Module électrique (1) selon la revendication 11, **caractérisé en ce que** le module comporte en outre un cinquième semi-conducteur de puissance (39) présentant une borne d'entrée reliée à la première surface de tension d'alimentation (10) et une borne de sortie reliée à une troisième sortie de tension alternative (20c) du circuit ; et
un sixième semi-conducteur de puissance (41) présentant une borne d'entrée reliée à la deuxième surface de tension d'alimentation (12) et une borne de sortie reliée à la troisième sortie de courant alternatif (20c) du module (1), dans lequel la deuxième surface de tension d'alimentation (12) s'étend sur la face du sixième semi-conducteur de puissance (41) qui est opposée à la borne de tension d'entrée du sixième semi-conducteur de puissance (41), et que la première surface de tension d'alimentation (10) s'étend sur la face du cinquième semi-conducteur de puissance qui est tournée vers la borne de tension d'entrée du cinquième semi-conducteur de puissance (39).

13. Véhicule automobile (74) comportant au moins un moteur d'entraînement électrique (76) et un module électrique (1) selon l'une des revendications précédentes, qui est relié au moteur d'entraînement (76).
